# EUROPEAN PATENT SPECIFICATION

(11) **EP 2 870 604 B1**
(45) Date of publication and mention of the grant of the patent: **14.11.2018**
(21) Application number: 13813880.5
(22) Date of filing: 01.07.2013
(51) Int. Cl.: G11C 11/22, G11C 14/00, G11C 5/14, G11C 7/24, G11C 8/20, G11C 16/22, G11C 7/20, G11C 7/10, G11C 19/00, H01L 27/11502, H03K 3/356

(54) **EMBEDDED NON-VOLATILE MEMORY CIRCUIT FOR IMPLEMENTING LOGIC FUNCTIONS ACROSS PERIODS OF POWER DISRUPTION**
EINGEBETTETE NICHTFLÜCHTIGE SPEICHERSCHALTUNG ZUR DURCHFÜHRUNG LOGISCHER FUNKTIONEN IN STROMUNTERBRECHUNGSPHASEN
CIRCUIT DE MÉMOIRE NON VOLATILE INTÉGRÉ POUR METTRE EN UVRE DES FONCTIONS LOGIQUES SUR DES PÉRIODES D'INTERRUPTION D'ALIMENTATION

(30) Priority: 06.07.2012 US 201213543652
(43) Date of publication of application: 13.05.2015
(73) Proprietor: Radiant Technologies, Inc., Albuquerque, NM 87107-1652 (US)
(72) Inventor: EVANS, Joseph, T., Albuquerque NM 87107-1652 (US)
(74) Representative: Dolleymores
(86) International application number: PCT/US2013/048982
(87) International publication number: WO 2014/008211

(56) References cited:
- US-A1- 2002 113 636
- US-A1- 2004 085 798
- US-A1- 2006 250 843
- US-A1- 2008 151 649
- US-A1- 2011 305 061
- US-B1- 6 314 016
- US-B2- 6 845 032
- US-B2- 6 980 459
- US-B2- 6 990 006
- US-B2- 7 990 749

## Description

### Background

Logic circuits that must operate across power disruptions are known to the art. The simplest form of such circuits utilizes some form of energy storage such as a battery to maintain the state of the system during the period in which the power that normally runs the circuit is off. Such systems are limited by the amount of power that can be stored. Some circuitry prolongs the period over which external power is not needed by entering a low power mode that maintains the state of the circuitry for an extended period of time.

A second class of circuits stores the state of the system in a non-volatile memory prior to powering down in the event of a power disruption. When power is restored, the system state is "reloaded" from the non-volatile memory and system operation continues. This type of system typically requires a separate save/restore mode. In one class of systems, the non-volatile memory that stores the state operates at different logic levels or frequencies than the circuitry whose state is being saved. For example, the non-volatile memory could be an EEPROM that operates as a shadow RAM. The voltages and cycle times needed to store information into the non-volatile memory are substantially different from those used by the logic circuits, and hence, the non-volatile memory cannot track the state of the system in real time such that the state of the system is always stored in the non-volatile memory. In addition, the save cycle requires a separate system mode that adds complexity and cost to the system.

A second class of non-volatile memory is based on ferroelectric memory devices. These devices operate at the same logic levels as the other circuitry, and can be read and written in times comparable to those of the logic circuitry. However, these non-volatile memory devices must be read and written synchronously, and hence, using such non-volatile memory devices for storing and restoring the state of the system still typically involves a separate save/restore procedure. Further, since these memories can be written by voltages that are within the normal logic levels of the associated circuitry, preventing alteration of the data stored therein during periods of power instability such as during power down or power up poses significant challenges.

A memory having a plurality of ferroelectric memory cells connected between first and second bit lines is known from US2011/0305061. Further prior art arrangements are known from US2002/113636, US6314016, US2004/085798 and US2006/250843.

### Summary

In the first aspect the present invention provides a circuit as recited in Claim 1.

The circuit could include a circuit element that performs an operation on the AML output to generate a circuit element output that is coupled to the AML input by the latch.

In a further aspect of the invention, there is provided a method for operating a circuit as recited by Claim 13.

### Brief Description of Drawings

Figure 1A is a schematic drawing of an autonomous memory circuit.
Figure 1B illustrates the potential on the power rail and on node 26 shown in Figure 1A as a function of time when autonomous memory circuit 20 is powered up with ferroelectric capacitor 21 in the UP and DOWN states.
Figure 2 is a schematic drawing of another autonomous memory circuit.
Figure 3 is a block diagram of a non-volatile latch that utilizes a feedback path.
Figure 4 is a schematic drawing of a non-volatile latch that utilizes field effect transistors (FETs).
Figure 5 illustrates an autonomous memory latch having an inverter buffer on the input.
Figures 6A and 6B illustrate the insertion of an AML into a logic path.
Figure 6C illustrates a non-volatile master-slave flip-flop according to one embodiment of the present invention.
Figure 7A illustrates a binary counter constructed from N single bit counters connected as a series chain.
Figure 7B illustrates a single bit counter that does not have an AML for preserving the state of the counter across power failures.
Figure 7C illustrates an embodiment of a single bit counter that includes an AML that preserves the counter's state across power failures.
Figure 7D illustrates a circular logic circuit in which an AML is located between a logic circuit and a volatile latch.
Figure 8 illustrates a shift register .
Figure 9 illustrates the manner in which power is managed in a circuit that includes one or more AMLs.
Figure 10 illustrates a circuit in which an AML is used to store the state of a node during the operation of a circuit and then used to restore that state at some later time.

### Detailed Description

The manner in which the present invention provides its advantages can be more easily understood with reference to a novel ferroelectric latch design that is described in U.S. Patent 7,990,749. For the purposes of this discussion, an AML will be defined to be a latch having an autonomous memory circuit and a feedback loop, wherein the autonomous memory circuit includes a ferroelectric capacitor, a conductive load and a switch having a current actuated control input that connects an output node to a first power rail, the conductive load connecting a second power rail to the output node, the ferroelectric capacitor being connected between the switch control input and the output node.

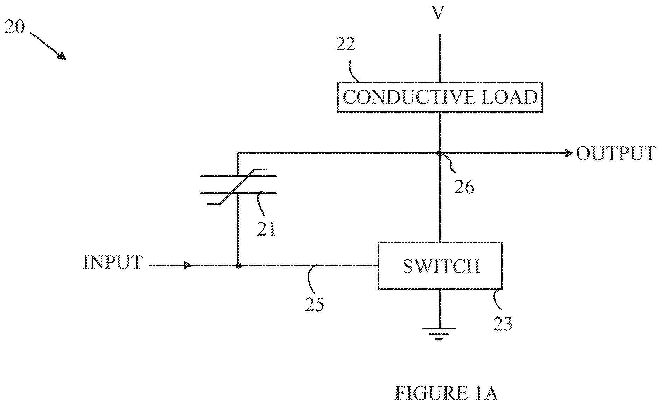

Refer first to Figure 1A, which is a schematic drawing of an autonomous memory circuit. Autonomous memory circuit 20 includes a ferroelectric capacitor 21 and a switch 23 having a current actuated control input 25. A conductive load 22 is connected between a power rail and switch 23.

Ferroelectric capacitor 21 has a remanent polarization that can be switched by applying a voltage across ferroelectric capacitor 21. That is, in the absence of a voltage across the capacitor, the dielectric of the capacitor is electrically polarized. For the purpose of this discussion, the dielectric has two states corresponding to the dielectric being polarized either up or down. If a voltage is applied across the ferroelectric capacitor, an electric field is created in the ferroelectric capacitor. If the field direction is the same as that of the remanent polarization, a small current flows in the circuit connecting the two plates of the ferroelectric capacitor. If, on the other hand, the applied electric field is in a direction opposite to that of the remanent polarization, the remanent polarization will change direction to conform to the new field direction, and a large current will flow in the external circuit. The magnitude of the current and the voltage at which it flows can be set by adjusting the composition, area, and thickness of the ferroelectric capacitor.

Switch 23 changes from a high impedance state to a low impedance state when a current enters current actuated control input 25. In autonomous memory circuit 20, it is assumed that the potential of the input line to switch 23 remains at or near ground independent of the state of the switch. To simplify the following discussion, it will be assumed that the power rail is positive and that the "UP" remanent polarization state is set when the positive rail potential, V, is applied across the plates of ferroelectric capacitor 21. However, other embodiments in which the input is referenced to power and the output is referenced to ground can be utilized.

First, assume that ferroelectric capacitor 21 is polarized in the UP state. When power is turned on, switch 23 is initially in the off state; hence, the potential at node 26 will increase to V. Thus, the field applied to ferroelectric capacitor 21 will also be in the UP direction, and ferroelectric capacitor 21 will not flip states. Accordingly, little current will flow into the input of switch 23, switch 23 will remain off, and the output of autonomous memory circuit 20 will quickly go to the potential of V.

Next, assume that ferroelectric capacitor 21 is polarized in the DOWN state. When power is turned on, the applied electric field across ferroelectric capacitor 21 will be opposite to that of the remanent polarization of ferroelectric capacitor 21, and ferroelectric capacitor 21 will flip states to match the applied electric field. In this case, a much larger current will flow into the control input of switch 23, and switch 23 will enter the conducting state. Node 26 will rise to an intermediate state that is less than V. The specific potential will depend on the details of the switch. This intermediate state will remain until ferroelectric capacitor 21 finishes switching to its UP state. At that point there will be no more charge flowing out of ferroelectric capacitor 21, and switch 23 will again enter the non-conducting state. Hence, the potential on node 26 will then increase back to V.

Thus, after power is turned on, autonomous memory circuit 20 will have a temporary output that depends on the state of polarization of ferroelectric capacitor 21 for the period of time needed for ferroelectric capacitor 21 to switch states. If ferroelectric capacitor 21 is UP when power is turned on and does not switch, the output will go high almost immediately. If ferroelectric capacitor 21 is DOWN when power is turned on and does switch, the output will go to the intermediate state characterized by voltage Vₛ for the temporary period and then will go high. After that temporary time period, the output will always be high, and ferroelectric capacitor 21 will be in the UP polarization state.

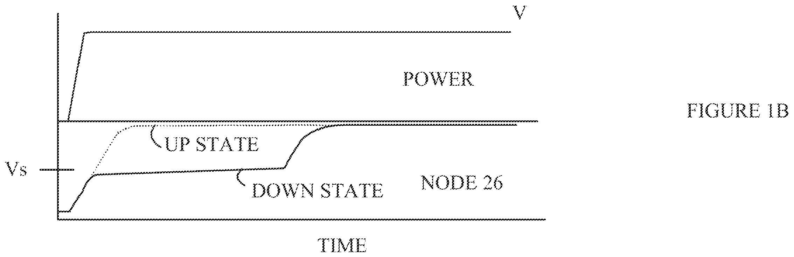

Refer now to Figure 1B, which illustrates the potential on the power rail and on node 26 shown in Figure 1A as a function of time when autonomous memory circuit 20 is powered up with ferroelectric capacitor 21 in the UP and DOWN states. If ferroelectric capacitor 21 is in the DOWN state when autonomous memory circuit 20 is powered up, the potential on node 26 initially increases with the power rail potential until the potential at node 26 reaches a value that causes ferroelectric capacitor 21 to begin to change polarization state. As ferroelectric capacitor 21 begins to flip polarization, charge is released that causes switch 23 to begin to conduct. If switch 23 begins to conduct too much, the potential on node 26 begins to drop and ferroelectric capacitor 21 stops switching. If switch 23 does not conduct enough, the potential on node 26 rises faster causing ferroelectric capacitor 21 to switch faster forcing more current into the control input of switch 23 increasing its conductivity. Thus, the circuit stabilizes with the potential of node 26 at a specific intermediate value with a slow rate of rise. In this manner, the change in conductivity of switch 23 limits the voltage rise at node 26 until the change in the state of ferroelectric capacitor 21 is completed. At this point, no further remanent charge will be released from ferroelectric capacitor 21, and hence, switch 23 will again become non-conducting and node 26 will rise to V. The potential during the transition of ferroelectric capacitor 21 will be referred to as the "shelf voltage", Vₛ, in the following discussion. The specific shape of the potential at node 26 will, in general, depend on the specific switch implementation.

Referring again to Figure 1B, and in particular the dotted curve, the potential on the power rail and on node 26 shown in Figure 1A is shown as a function of time when autonomous memory circuit 20 is powered up with ferroelectric capacitor 21 in the UP state. Since ferroelectric capacitor 21 does not switch on at power up, little current flows into the control input of switch 23 and switch 23 never conducts. The potential on node 26 immediately rises to the voltage on the power rail.

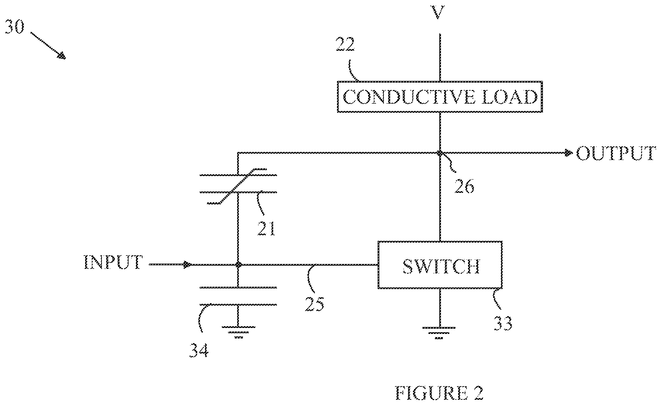

Refer now to Figure 2, which is a schematic drawing of another embodiment of an autonomous memory circuit. Autonomous memory circuit 30 differs from autonomous memory circuit 20 in that switch 33 switches on a voltage signal rather than a current signal, and capacitor 34 has been added to provide a charge-to-voltage conversion. If ferroelectric capacitor 21 is in the UP state when power is applied, ferroelectric capacitor 21 will remain in the UP state and switch 33 will not become conductive because little charge is received by capacitor 34.

If ferroelectric capacitor 21 is in the DOWN state when power is applied, ferroelectric capacitor 21 will start to flip its polarization as power increases. The change in polarization gives rise to a charge that is released and stored on capacitor 34, thereby raising the potential at the input to switch 33. If capacitor 34 is correctly chosen, the increase in potential on current actuated control input 25 will be sufficient to cause switch 33 to conduct, thereby lowering the potential on node 26. Node 26 will remain at an intermediate potential between ground and V as long as ferroelectric capacitor 21 is changing state. Once ferroelectric capacitor 21 changes state completely, no additional charge will be stored on capacitor 34. The charge on capacitor 34 will then leak off at a rate determined by the leakage current in switch 33. At this point, switch 33 will again become non-conducting, and node 26 will rise to V. Hence, autonomous memory circuit 30 behaves in a manner analogous to autonomous memory circuit 20 discussed above. That is, during power up, the output signal can be monitored to determine the state of ferroelectric capacitor 21 prior to power up. After power up has been completed, the output will be high and ferroelectric capacitor 21 will be in the UP state.

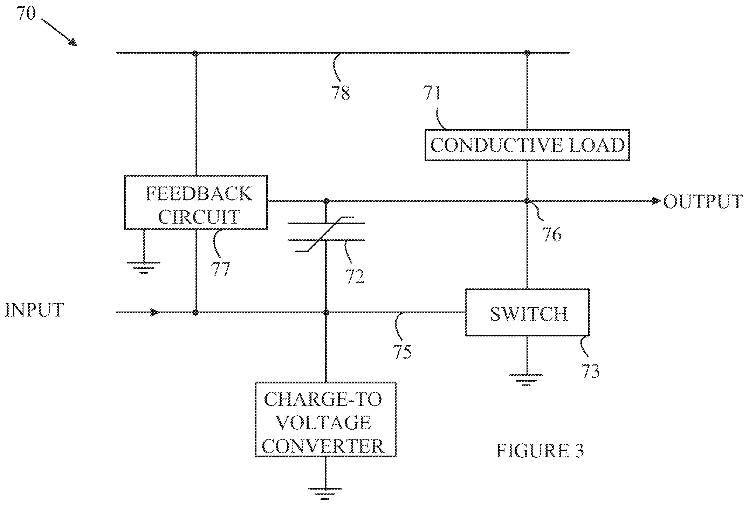

The autonomous memory circuit described above can be combined with a feedback path to construct a non-volatile latch. Refer now to Figure 3, which is a block diagram of a non-volatile latch 70 that utilizes such a feedback path. Feedback circuit 77 in non-volatile latch 70 measures the difference in potential between node 76 and power rail 78 as the autonomous memory circuit powers up. If the potential difference across load 71 is greater than a predetermined threshold value, feedback circuit 77 generates a signal on line 75 that causes switch 73 to enter the conducting state, node 76 to go low, and ferroelectric capacitor 72 to be set to the DOWN state. With switch 73 on, the control input for feedback circuit 77 is held permanently on and the circuit latches. If the potential difference across load 71 is less than that predetermined threshold value, the feedback circuit remains off, switch 73 remains off, node 76 goes high, and ferroelectric capacitor 72 is set to the UP state.

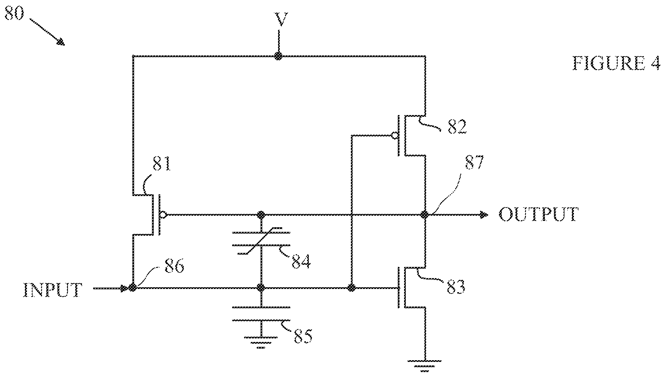

Refer now to Figure 4, which is a schematic drawing of one embodiment of a non-volatile latch 80 that utilizes FETs. Feedback transistor 82 acts as the conducting load in non-volatile latch 80. During power up, the potential on the gate of feedback transistor 81 will either be V or Vₛ, where Vₛ is the reduced voltage that is present on node 87 during the time ferroelectric capacitor 84 is changing polarization states. If the potential is V, feedback transistor 81 stays totally off, and hence, feedback transistor 81 provides a high impedance. In this case, feedback transistor 81 never turns on and transistor 83 stays off. Output goes high and ferroelectric capacitor 84 remains programmed in the UP state.

If the Vₛ is generated at node 87, feedback transistor 81 is subjected to a negative potential between the drain and gate that is sufficient to turn feedback transistor 81 on, and hence, feedback transistor 81 provides a very low impedance if the shelf voltage is generated at node 87. If feedback transistor 81 turns on, transistor 83 turns on, pulling node 86 to V and node 87 to ground, and hence, applying all of V to ferroelectric capacitor 84 to switch ferroelectric capacitor 84 back to the DOWN state. Non-volatile latch 80 can be programmed while non-volatile latch 80 is powered by pulling node 87 to ground to turn on feedback transistor 81 or pulling node 86 to ground to turn off feedback transistor 81.

The threshold criteria described above is met by designing the circuit so that the difference between the shelf voltage, Vₛ, and V is greater than the threshold voltage of feedback transistor 81. The charge-to-voltage conversion is provided by capacitor 85.

It should be noted that non-volatile latch 80 must be isolated by high impedance circuits. If the circuit that provides the input signal presents a low impedance to feedback transistor 81 when node 86 is high, node 86 can be dragged down to a low voltage, and hence, cause a change of state for the latch. Similarly if the circuit being driven by the output has a low impedance, node 87 can be dragged to a low voltage when the output of the latch at node 87 is supposed to be high.

It should also be noted that non-volatile latch 80 is an inverter. A low signal on the input leads to a high signal on the output, and a high signal on the input leads to a low signal on the output. Hence, if the latch is to be inserted in a logic line as described below, an inverter must be present on either the input or the output of the latch. This inverter can also buffer the input or output to provide the high impedance for the input or the output discussed above.

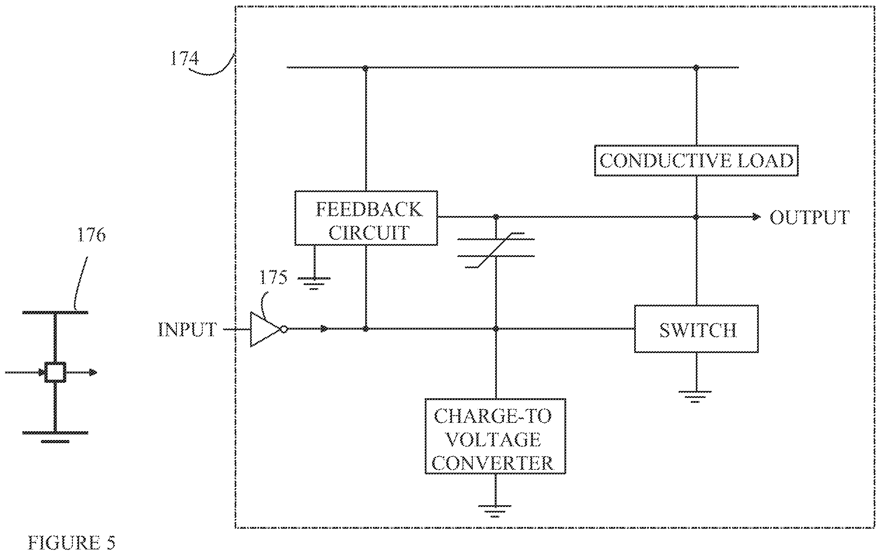

To simplify the following discussion, it will be assumed that an inverter/buffer is included on the input of the AML; however, the inverter/buffer could also be on the output of the AML. Refer now to Figure 5, which illustrates an AML 174 having an inverter/buffer 175 on the input. In the following discussion, such an AML in series with an inverter, either on the input or the output, will be denoted by the symbol shown at 176 unless the particular application requires that only one of these possibilities will function. In that case, the symbol denotes only the possible functioning alternative.

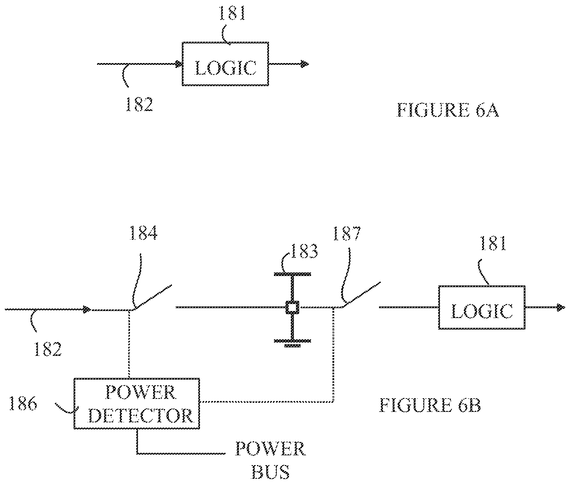

An AML according to the present invention can be embedded in logic such that the state of the logic can be preserved across power interruptions. Refer now to Figures 6A and 6B which illustrate the insertion of an AML according to the present invention into a logic path. Referring to Figure 6A, assume that the device includes a logic circuit 181 that receives an input on line 182 and produces some output. If power is lost, the state of the system is lost because the logic level on line 182 is lost. Refer now to Figure 6B. An AML 183 can be inserted into line 182 to capture the logic value on line 182. Since the AML does not alter the logic level on the line into which it is inserted, the presence of the AML does not alter the logic circuit since the output of the AML merely follows the input of the AML. However, when power is lost, the AML stores the state of line 182 prior to the power loss. Hence, when power is returned, the AML re-establishes the stored logic level to the input of logic circuit 181.

As noted above, the AML can be written and read at the same logic levels as utilized by logic circuit 181. Hence, the AML must be protected from transients on the input and output of AML 183 during power failures and the powering up of the circuit. This protection can be provided by a switch 184 that isolates AML 183 from line 182 when power is off or unstable, i.e., during power up and power down. The switch is operated by a power detection circuit 186 that closes the switch when power is on and stable and opens the switch in response to a determination that power is failing. The power protection circuit must store sufficient power to generate the open switch signal before power is completely lost. Switch 184 is preferably a normally open switch which is closed by the signal from power detection circuit 186.

In the example discussed with respect to Figures 6A and 6B, it is assumed that the input to logic circuit 181 has sufficiently high impedance and is free from transients during power up and power down. If transients are present on this line, a second isolation switch of the type shown at 184 must be inserted into line 182 between AML 183 and logic circuit 181 as shown at switch 187.

It should be noted that switch 187 could be part of logic circuit 181 provided switch 187 can be operated to provide the isolation of AML 183 without causing problems for logic circuit 181. For example, if the first stage of logic circuit 181 is a transparent latch, i.e., a cross-coupled buffer with a switch that enables input into the buffer to capture a value, the switch could provide the required isolation. Similarly, if the AML is driven by a latch with an output switch, e.g. a transparent latch with output enabled, the output switch of the latch could provide the required isolation provided by switch 184.

The arrangement shown in Figure 6B will be referred to as "inline" logic. If the output of logic circuit 181 is routed back to a point in the circuitry that alters the logic level on line 182, a more complicated isolation arrangement is needed. A circuit in which the output is coupled back to the input in a manner that alters the input will be referred to as "circular" logic.

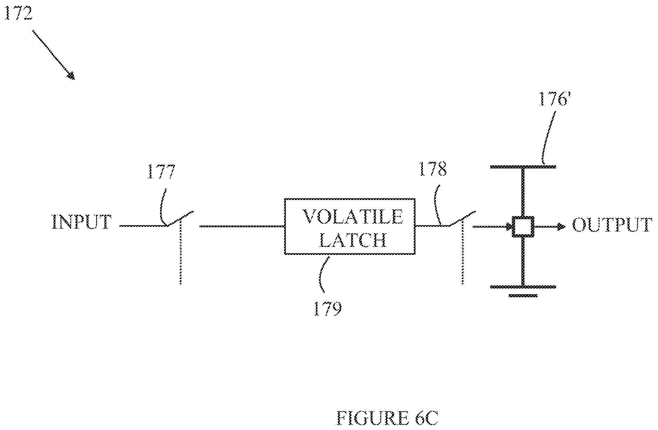

Some aspects of the present invention can be more easily understood with reference to a circuit that will be referred to as non-volatile master-slave flip-flop (NVFF). Refer now to Figure 6C, which illustrates an NVFF according to one embodiment of the present invention. NVFF 172 includes a conventional volatile latch 179 that is connected to AML 176' by a first switch 178. The input to volatile latch 179 is connected to the NVFF input by a second switch 177. During power up and power down, switch 177 must be open to protect the contents of AML 176' from being altered by transients during the power up or power down operation.

NVFF 172 can be operated so that the input to NVFF 172 is never directly connected to the output of NVFF 172. During normal operation, there are two possible switching sequences having 3 steps. In the first sequence, switches 177 and 178 start with both switches open. Next, switch 177 is closed and then opened. Next, switch 178 is closed and then opened. In the second sequence, switch 177 is closed and switch 178 is open. Next, switch 177 is opened, followed by closing switch 178. Next switch 178 is opened followed by closing switch 177.

It should also be noted that the relative positions of volatile latch 179 and AML 176' can be reversed. That is, an NVFF consisting of switch 177 connected to AML 176' whose output is connected to switch 178 which is connected to volatile latch 179 will also function. Hence, an NVFF will be defined to be a circuit having an input and output and four components connected in series. The first component is a switch connected to the input. The second component is one of a latch or an AML, the second component being connected to the first switch. The third component is a second switch that connects the output of the first component to the fourth component. The fourth component is the other of the latch or AML. The output of the NVFF being the output of the fourth component.

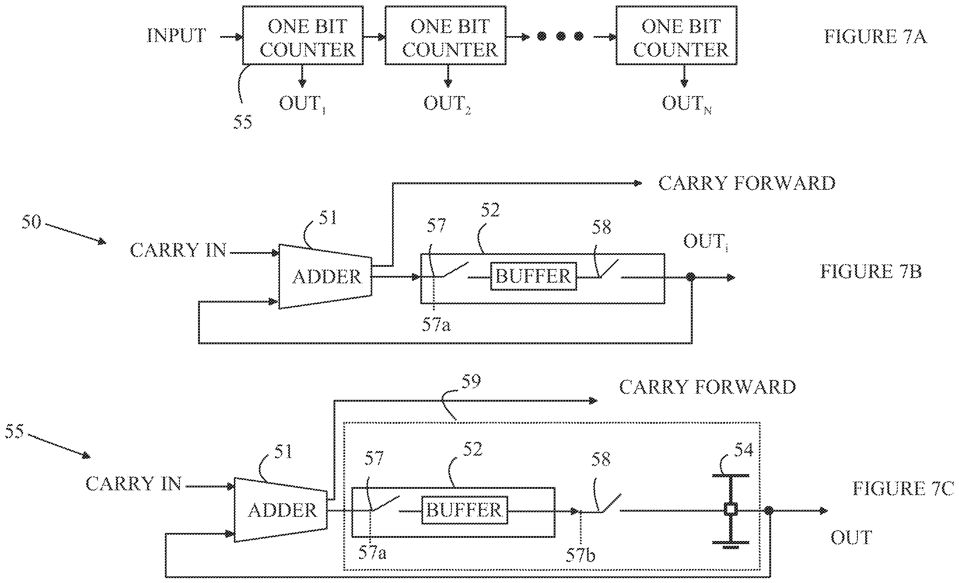

The manner in which an AML is used in a circular logic configuration will now be explained with reference to a simple binary counter circuit that is constructed from a plurality of single bit counter circuits. Refer now to Figures 7A-7C, which illustrate a binary counter constructed from a plurality of single bit counters and embodiments of single bit counters constructed with and without an AML. Referring to Figure 7A, the binary counter is constructed from N single bit counters connected as a series chain. Single bit counter 55 is an exemplary counter. Each single bit counter receives an input signal and generates two output signals. The first output signal is a carry forward signal that provides the input to the next single bit counter in the chain. The second output is the binary count associated with that bit, shown at OUT₁, OUT₂, ...OUT_{N}.

Refer now to Figure 7B, which illustrates a single bit counter 50 that does not have an AML for preserving the state of the counter across power failures. Single bit counter 50 includes an adder 51 and a transparent latch 52. Transparent latch 52 prevents a race condition in which the output of adder 51 would be directly fed back to the corresponding input of adder 51. Transparent latch 52 includes an input enable switch 57 and a cross-coupled buffer. Input enable switch 57 is controlled by a signal on control line 57a. The output of transparent latch 52 includes an output enable switch 58. To prevent a race condition, switches 57 and 58 must never be closed simultaneously. A device that includes switch 57, transparent latch 52, and switch 58 is called a transparent latch with output control.

Adder 51 adds the two bits input thereto to generate an output that is stored in transparent latch 52 and a carry forward signal. If both signals input to adder 51 are "0", adder 51 generates a "0" for both its output and carry forward. If one input is a "0" and the other is a "1", then adder 51 generates a "1" for its output and a "0" for its carry forward signal. Finally, if both inputs are a "1", adder 51 generates a "1" for its output and a "1" for its carry forward signal. If power is lost, the contents of the latches are lost.

Refer now to Figure 7C, which illustrates an embodiment of a single bit counter 55 that includes an AML that preserves the counter's state across power failures. Single bit counter 55 differs from single bit counter 50 in that an additional switch 58 that is controlled by a signal on control line 57b has been introduced after transparent latch 52 as shown at switch 58, and an AML 54 has been placed in the output line. In general, circular logic must have two switches in the feedback path to prevent an analog closed loop from forming from the output of the autonomous memory back to its input. The circuit shown at 59 is an example of an NVFF discussed above. As noted above, the order of the conventional latch, i.e., cross-coupled buffer in transparent latch 52 and AML 54 could also be reversed, and the circuit would still function as intended.

In circular logic, the autonomous memory must be isolated from the other circuits in two ways at two different times. First, when recalling the data from the autonomous bit, the input of the AML must be disconnected from the outputs of the other circuitry so that spurious outputs by the circuitry as it processes its new inputs do not asynchronously overwrite the data in the latch. Second, when storing the data back into the AML after work has been performed on the data, there must be a circuit on the output of the other circuit to capture the result of that circuit but hold it isolated from the output of the circuit when the result is transferred to the input of the autonomous memory latch. This second requirement is needed because as soon as the result is loaded into the autonomous memory latch, the output of the circuit that produced the input to the latch may begin to change, and that change should be ignored.

In the embodiment shown in Figure 7C, the input enable switch that is part of transparent latch 52 was used as one of the two switches required in circular logic. This embodiment depends on the fact that input enable switch 57 can be operated during the power up and down cycles without altering the operation of the circuit. In other embodiments, a separate switch could be introduced in the circular path to provide the required switch so that the switch can be operated independently of the switches that are part of the transparent latches in the circuitry.

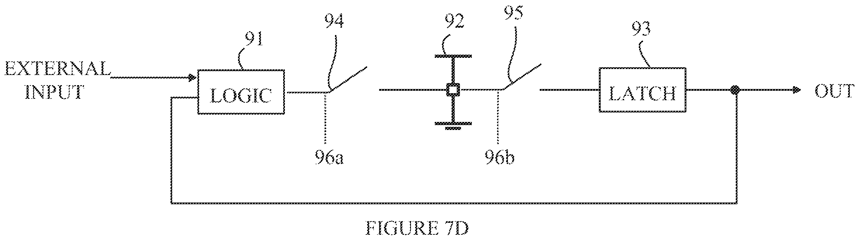

In the embodiment shown in Figure 7C. the volatile latch is located between the logic element and the AML. However, embodiments in which the AML is located between the logic device and the AML can also be utilized. Refer now to Figure 7D, which illustrates a circular logic circuit in which AML 92 is located between a logic circuit 91 and a volatile latch 93. Switches 94 and 95 are operated in a manner analogous to switches 57 and 58 shown in Figure 7C. The manner in which control lines 96a and 96b are operated will be discussed in more detail below.

The clocked embodiments can be used to construct a class of devices that will be referred to as sequential logic devices. Sequential logic is defined to be a plurality of combinatorial logic blocks separated by NVFFs, A combinatorial logic block is defined to be a logic block having one or more inputs and one or more outputs, the combinatorial logic block processing the inputs to generate the outputs. The combinatorial logic block does not include any memory elements that store previous results and whose stored values are used in computing the current output.

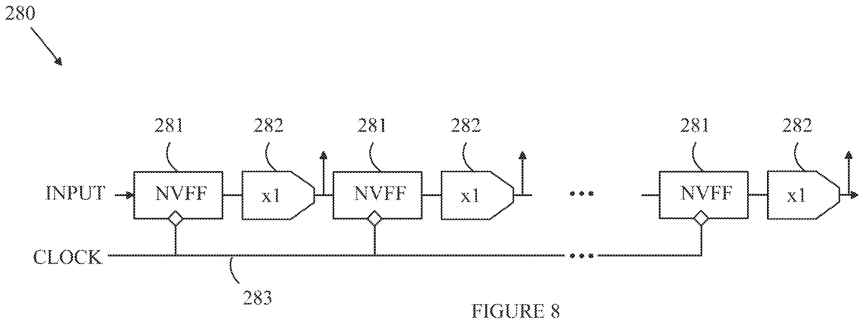

A shift register can be viewed as a sequential logic circuit having a plurality of stages in which the combinatorial logic blocks are blocks that just copy the input to the combinatorial logic block to the output of the combinatorial logic block, i.e.. multiply the input by "1". Refer now to Figure 8, which illustrates an embodiment of a shift register according to the present invention. Shift register 280 is constructed from a plurality of clocked NVFFs 281 that are connected in series with a multiply by one combinatorial logic block 282. The shift registers are clocked on Line 283. Shift register 280 can be used to convert a serial data stream into a parallel data stream by tapping the outputs of each of the combinatorial logic blocks. Shift register 280 can also be used as a delay circuit. During a period of power interruption, shift register 280 retains the bits stored therein prior to the power interruption.

In the more general case, the combinatorial logic blocks shown at combinatorial logic block 282 would be replaced by combinatorial logic blocks having different functions. The combinatorial logic blocks within a given device do not need to be the same. Furthermore, the combinatorial logic blocks can have additional inputs and outputs depending on the particular circuit. For example, the combinatorial logic blocks in the counter shown in Figure 7C are adders.

It should be noted that circular logic that includes an AML must always have a latch and two switches in the feedback path to ensure that the feedback path from the AML output to its input is always interrupted. In some cases, the latch may be part of the existing circuitry as was the case with the counter discussed above with respect to Figures 7A-7C. The switches are operated as discussed above with reference to Figure 6C.

It should be noted that inline uses of AMLs only require a single switch to isolate the input to the AML during changes in the state of the power system or periods in which the level of the input to the AML is not to be copied into the AML. This assumes, however, that the output of the AML is connected to a high impedance and that no voltage spikes propagate in the reverse direction during a power failure.

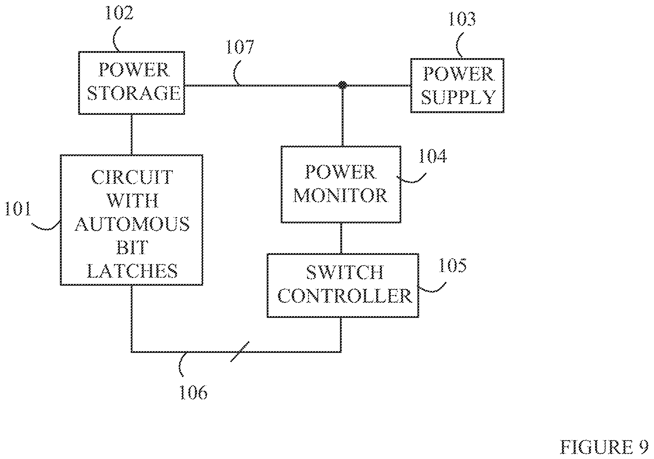

Refer now to Figure 9, which illustrates the manner in which power is managed in a circuit that includes one or more AMLs. The power supply 103 that powers the circuit 101 that includes the AMLs must store sufficient power to carry the system for the length of time needed to open the various switches that protect the AMLs after a power failure is detected. Circuit 101 is powered by providing a potential between first and second terminals on circuit 101. The power needed during the shutdown is stored in power storage component 102 which maintains the potential between the first and second terminals. The amount of power that must be stored is that which is needed to power circuit 101 for the length of time needed to open the various protection switches that are embedded in circuit 101. In one aspect of the invention, power storage component 102 includes a capacitor that stores the required energy. The amount of energy needed depends on the time needed to open the various protection switches, but, in general, will be less than the power needed to operate circuit 101 for a few microseconds.

In one aspect of the invention, the power on power bus 107 is monitored by a power monitor 104. When power monitor 104 detects a loss of power from power supply 103 by observing a potential on power bus 107 that decreases to a value less than a predetermined value, power monitor 104 signals switch controller 105 which controls the state of the various protection switches in circuit 101 via bus 106.

The manner in which circuit 101 is powered up is somewhat more complicated and, in general, will depend on the details of circuit 101. The power up sequence assures that circuit 101 resume operation in a state that existed prior to power monitor 104 detecting the power failure. Refer again to Figure 7D. As noted above, on power up, switches 94 and 95 are open. After sufficient time for AML 92 to stabilize its output, switch 95 is closed but switch 94 remains open. After a time period that is sufficient for the results of volatile latch 93 being connected to logic circuit 91 to have stabilized, switch 94 is closed, and circuit operation can commence. If logic circuit 91 also includes an AML, additional timing delays may be required to ensure that the additional AMLs have time to stabilize before being connected back into the circuit. For any given circuit design, a power up program for the AMLs can be designed to ensure that the AMLs are not disturbed by transients during the power up process.

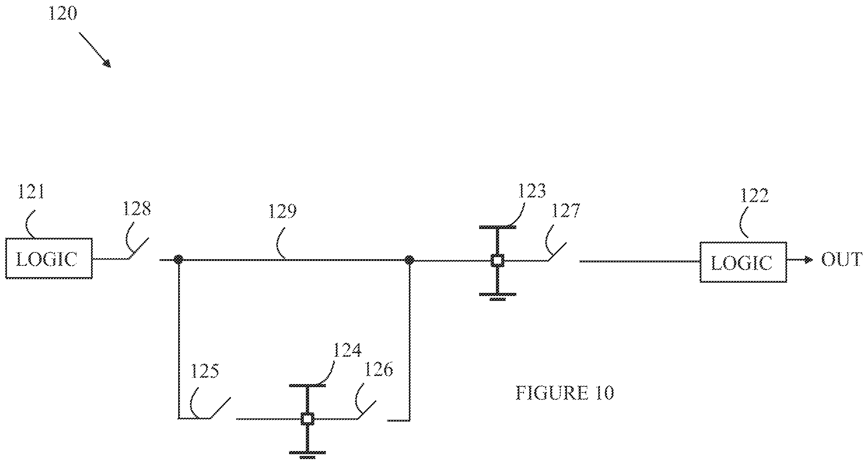

In the above-described embodiments, the AMLs are utilized to store a state of a circuit across a power interruption by inserting the AMLs in the circuit paths in a manner in which the AMLs are invisible to the operation of the circuit during normally powered operation. However, embodiments in which the AMLs are used to store other states during the operation of a circuit can also be constructed. For example, an AML can be utilized to store a state of the circuit during normal operation that is to be recalled later after the state of the circuit has changed due to the operation of the circuit. Refer now to Figure 10, which illustrates a circuit in which an AML is used to store the state of a node during the operation of a circuit and then used to restore that state at some later time. Circuit 120 includes two logic circuits 121 and 122 that are connected through a first AML 123 whose input is derived from node 129. AML 123 and switches 127 and 128 operate in an inline configuration to preserve the state of node 129 in a manner analogous to that described above. In normal operation, switches 128 and 127 are closed. At some point in the operation of circuit 120, the state of node 129 is read into a second AML 124 by closing switch 125. At some subsequent time, the contents of AML 124 are used to re-establish the state of node 129 by opening switches 128 and 125 and closing switch 126. The choice of times to store and recover the level on node 129 depends on the overall circuit in which circuit 120 is located. It should be noted that the value stored in AML 124 could also be a "reset" value that is permanently stored in AML 124 and used to reset node 129. In this case, switch 125 would be absent. In one embodiment, the input to AML 124 comes from an external bus to allow external programming of the stored state that will be present at start-up.

It should be noted that circular logic includes an AML with an input switch in series with a latch with an input enable switch. To simplify the discussion, define an AML with an input switch as a transparent AML. A latch with an input enable switch is normally referred to as a transparent latch. Hence, the simplest circular logic circuit consists of a circuit element having an input and an output that is placed in series with an AML circuit that includes a transparent AML and a transparent latch connected in series. Figure 7D illustrates the case in which the transparent AML is connected between the circuit element, i.e., logic circuit 91, and the transparent latch consisting of switch 95 and volatile latch 93. Figure 7C illustrates the case in which the transparent latch is between the circuit element, i.e., adder 51, and the transparent AML consisting of switch 58 and AML 54. In either case, the AML circuit has an input that is connected to the circuit element output and an AML circuit output that is connected to the input of the circuit element.

In more complex arrangements, there may be other circuit elements between the transparent AML and the transparent latch. Similarly, there may be other circuit elements between the output of the AML circuit and the input of the circuit element. In the later case, the other circuit elements can be considered to be part of the circuit element. To simplify the following discussion, the case in which there are additional elements between the AML and the latch will also be referred to as a circuit in which the AML and latch are connected in series.

The above-described embodiments of the present invention have been provided to illustrate various aspects of the invention. However, it is to be understood that different aspects of the present invention that are shown in different specific embodiments can be combined to provide other embodiments of the present invention. In addition, various modifications to the present invention will become apparent from the foregoing description and accompanying drawings. Accordingly, the present invention is to be limited solely by the scope of the following claims.

## Claims

1. A circuit comprising:
an autonomous ferroelectric memory latch, AML (176', 54, 92), having an autonomous memory circuit and a feedback loop, wherein the autonomous memory circuit includes a ferroelectric capacitor (21), a conductive load (22) and a switch (23) having a current actuated control input (25) that connects an output node to a first power rail, the conductive load connecting a second power rail to the output node (26), the ferroelectric capacitor being connected between the switch control input and the output node, said AML comprising an AML input, an AML output, a first AML power contact, a second AML power contact and an AML state wherein the feedback loop comprises: a first power contact coupled to the first power rail, a second power contact coupled to the second power rail, a feedback control input node coupled to the output node (26) and a feedback output node coupled to the current actuated control input (25), the AML input is coupled to the current actuated control input (25), the AML output is directly coupled to the output node (26), the first AML power contact is directly coupled to the first power rail, and the second AML power contact is directly coupled to the second power rail; **characterised by**:
a first switch (178, 58, 95) in series with one of said AML input or said AML output;
a second switch (177, 57, 94) in series with the other of said AML input or said AML output;
a latch (179, 52, 93) in series with said AML input or said AML output, said latch being positioned such that a direct path does not exist between said AML output and said AML input; and
a switch controller configured to open said first and second switches prior to power being removed from said first and second AML power contacts.

2. The circuit of Claim 1 further comprising a circuit element configured to perform an operation on said AML output or provide said AML input.

3. The circuit of Claim 1, wherein the switch controller is configured to prevent said first and second switches from being closed at the same time.

4. The circuit of Claim 1 wherein one of said first and second switches is part of said latch.

5. The circuit of Claim 1 wherein said circuit includes a circuit element configured to perform an operation on said AML output to generate a circuit element output that is coupled to said AML input by said latch.

6. The circuit of Claim 5 wherein said latch is located between said AML output and an input to said circuit element or is located between an output of said circuit element and said AML input.

7. The circuit of Claim 1 wherein said first and second switches are open when power is not provided between said first and second AML power contacts and wherein said switch controller is configured to close said first and second switches in a predetermined order after power is provided between said first and second AML power contacts.

8. The circuit of Claim 7 wherein said switch controller is configured to delay closing one of said first and second switches for a period of time after the other of said first and second switches are closed, said period of time being sufficient to allow said circuit to achieve a predetermined state prior to said closing of the other of said first and second switches.

9. The circuit of Claim 1 further comprising
a power supply and a power storage component, said power supply configured to provide power to said first and second power contacts, said power storage component configured to provide power to said first and second power contacts for a period of time sufficient for said switch controller to open said first and second switches; and
a power monitor, said power monitor configured to detect a power interruption from said power supply and to cause said switch controller to operate said first and second switches in response thereto.

10. The circuit of Claim 1 further comprising
a plurality of said AMLs embedded in logic circuitry,
first and second power terminals, said circuit configured to be powered by a potential applied between said first and second power terminals; and
a power monitoring circuit, said power monitoring circuit configured to monitor said potential between said first and second power terminals, said power monitoring circuit configured to disconnect said AMLs from circuit components connected thereto when said potential is less than a predetermined value, and said power monitoring circuit configured to reconnect said AMLs to said circuit components in a predetermined sequence such that said circuit resumes operation in a state that existed prior to said potential decreasing to a value less than said predetermined value when said potential increases from a value less than said predetermined value to a value greater than said predetermined value.

11. The circuit of Claim 10 comprising a plurality of stages connected to form a counter, each stage comprising one of said AMLs connected such that said counter will resume counting after a power interruption.

12. The circuit of Claim 10 comprising a plurality of stages connected to form a shift register storing a plurality of bits, each stage comprising one of said AMLs connected such that said shift register retains said plurality of bits during a power interruption.

13. A method for operating a circuit that has been powered down, said circuit comprising a circuit element (91) comprising a circuit element input and a circuit element output and an AML circuit comprising a transparent latch comprising a latch (93) and an input switch (95) connected to an input of said latch (93), and a transparent autonomous ferroelectric memory latch, transparent AML, comprising an autonomous ferroelectric memory latch, AML (92), and an input switch (94) connected to an input of said AML (92), said transparent latch and said transparent AML being connected in series, said circuit element input being connected to the output of said transparent latch and said circuit element output being connected to said input switch (94) of said transparent AML, said AML (92) comprising an autonomous memory circuit (20) and a feedback loop, wherein the autonomous memory circuit includes a ferroelectric capacitor (21), a conductive load (22) and a switch (23) having a current actuated control input (25) that connects an output node to a first power rail, the conductive load connecting a second power rail to the output node (26), the ferroelectric capacitor being connected between the switch control input and the output node, the feedback loop comprising: a first power contact coupled to the first power rail, a second power contact coupled to the second power rail, a feedback control input node coupled to the output node (26) and a feedback output node coupled to the current actuated control input (25), the AML input being coupled to the current actuated control input (25), the AML output being directly coupled to the output node (26), the first AML power contact being directly coupled to the first power rail, and the second AML power contact being directly coupled to the second power rail, said AML circuit having an AML circuit input connected to said circuit element output and an AML circuit output connected to said circuit element input, said method comprising:
isolating said AML circuit input from said circuit element output and isolating said transparent latch from said transparent AML;
powering up said circuit, while maintaining said isolation;
connecting said transparent AML to said transparent latch for a first period of time by closing said input switch (95) of said transparent latch after said transparent AML has recalled a value stored therein;
disconnecting said transparent AML from said transparent latch by opening said input switch (95) of said transparent latch ;
connecting said circuit element output to said AML input by closing said input switch (94) of said transparent AML; and
disconnecting said transparent AML from the circuit element output by opening said input switch (95) of said transparent AML.

## Patentansprüche

1. Stromkreis, der Folgendes umfasst:
einen autonomen ferroelektrischen Memory-Latch (AML) (176', 54, 92) mit einem autonomen Speicherstromkreis und einer Rückkopplungsschleife, wobei der autonome Speicherstromkreis einen ferroelektrischen Kondensator (21), einen leitfähigen Verbraucher (22) und einen Schalter (23) mit einem strombetätigten Steuereingang (25), der einen Ausgangsknoten mit einer ersten Stromschiene verbindet, umfasst, wobei der leitfähige Verbraucher eine zweite Stromschiene mit dem Ausgangsknoten (26) verbindet, wobei der ferroelektrische Kondensator zwischen dem Schaltersteuereingang und dem Ausgangsknoten angeschlossen ist, wobei der AML einen AML-Eingang, einen AML-Ausgang, einen ersten AML-Stromkontakt, einen zweiten AML-Stromkontakt und einen AML-Zustand umfasst, wobei die Rückkopplungsschleife Folgendes umfasst: einen an die erste Stromschiene gekoppelten ersten Stromkontakt, einen an die zweite Stromschiene gekoppelten zweiten Stromkontakt, einen an den Ausgangsknoten (26) gekoppelten Rückkopplungssteuereingangsknoten und einen an den strombetätigten Steuereingang (25) gekoppelten Rückkkopplungsausgangsknoten, wobei der AML-Eingang an den strombetätigten Steuereingang (25) gekoppelt ist, der AML-Ausgang direkt an den Ausgangsknoten (26) gekoppelt ist, der erste AML-Stromkontakt direkt an die erste Stromschiene gekoppelt ist und der zweite AML-Stromkontakt direkt an die zweite Stromschiene gekoppelt ist; **gekennzeichnet durch**:
einen ersten Schalter (178, 58, 95) in Reihe mit einem von dem AML-Eingang und dem AML-Ausgang;
einen zweiten Schalter (177, 57, 94) in Reihe mit dem anderen von dem AML-Eingang und dem AML-Ausgang;
einen Latch (179, 52, 93) in Reihe mit dem AML-Eingang oder dem AML-Ausgang, wobei der Latch derart positioniert ist, dass es keinen direkten Weg zwischen dem AML-Ausgang und dem AML-Eingang gibt; und
einen Schalterkontroller, der dazu konfiguriert ist, den ersten und den zweiten Schalter zu öffnen, bevor Strom von dem ersten und dem zweiten AML-Stromkontakt entfernt wird.

2. Stromkreis nach Anspruch 1, weiter umfassend ein Stromkreiselement, das dazu konfiguriert ist, eine Operation an dem AML-Ausgang auszuführen oder den AML-Eingang bereitzustellen.

3. Stromkreis nach Anspruch 1, wobei der Schalterkontroller dazu konfiguriert ist, zu verhindern, dass der erste und der zweite Schalter gleichzeitig geschlossen werden.

4. Stromkreis nach Anspruch 1, wobei einer von dem ersten und dem zweiten Schalter Teil des Latch ist.

5. Stromkreis nach Anspruch 1, wobei der Stromkreis ein Stromkreiselement umfasst, das dazu konfiguriert ist, eine Operation an dem AML-Ausgang auszuführen, um einen Stromkreiselementausgang zu erzeugen, der von dem Latch an den AML gekoppelt wird.

6. Stromkreis nach Anspruch 5, wobei sich der Latch zwischen dem AML-Ausgang und einem Eingang zu dem Stromkreiselement befindet oder sich zwischen einem Ausgang des Stromkreiselements und dem AML-Eingang befindet.

7. Stromkreis nach Anspruch 1, wobei der erste und der zweite Schalter offen sind, wenn kein Strom zwischen dem ersten und dem zweiten AML-Stromkontakt bereitgestellt wird, und wobei der Schalterkontroller dazu konfiguriert ist, den ersten und den zweiten Schalter in einer vorbestimmten Reihenfolge zu schließen, nachdem Strom zwischen dem ersten und dem zweiten AML-Stromkontakt bereitgestellt wird.

8. Stromkreis nach Anspruch 7, wobei der Schalterkontroller dazu konfiguriert ist, das Schließen von einem von dem ersten und dem zweiten Schalter für einen Zeitraum zu verzögern, nachdem der andere von dem ersten und dem zweiten Schalter geschlossen wurde, wobei der Zeitraum ausreicht, um zu ermöglichen, dass der Stromkreis vor dem Schließen des anderen von dem ersten und dem zweiten Schalter einen vorbestimmten Zustand erreicht.

9. Stromkreis nach Anspruch 1, der weiter Folgendes umfasst:
eine Stromversorgung und eine Stromspeicherkomponente, wobei die Stromversorgung dazu konfiguriert ist, dem ersten und dem zweiten Stromkontakt Strom bereitzustellen, wobei die Stromspeicherkomponente dazu konfiguriert ist, dem ersten und dem zweiten Stromkontakt für einen Zeitraum Strom bereitzustellen, der dazu ausreicht, dass der Schalterkontroller den ersten und den zweiten Schalter öffnet; und
eine Stromüberwachung, wobei die Stromüberwachung dazu konfiguriert ist, einen Stromausfall von der Stromversorgung zu erkennen und den Schalterkontroller zu veranlassen, als Reaktion darauf, den ersten und den zweiten Schalter zu betätigen.

10. Stromkreis nach Anspruch 1, der weiter Folgendes umfasst:
eine Vielzahl der AMLs, die in einer Logikschaltung eingebettet sind,
eine erste und eine zweite Stromklemme, wobei der Stromkreis dazu konfiguriert ist, von einem zwischen der ersten und der zweiten Stromquelle angelegten Potential versorgt zu werden; und
einen Stromüberwachungsstromkreis, wobei der Stromüberwachungsstromkreis dazu konfiguriert ist, das Potential zwischen der ersten und der zweiten Stromklemme zu überwachen, wobei der Stromüberwachungsstromkreis dazu konfiguriert ist, die AMLs von den damit verbundenen Stromkreiskomponenten abzutrennen, wenn das Potential geringer als ein vorbestimmter Wert ist, und wobei der Stromüberwachungsstromkreis dazu konfiguriert ist, die AMLs in einer vorbestimmten Reihenfolge wieder mit den Stromkreiskomponenten zu verbinden, sodass der Stromkreis den Betrieb in einem Zustand wieder aufnimmt, der vorlag, bevor das Potential auf einen geringeren Wert als den vorbestimmten Wert gesunken ist, wenn das Potential von einem geringeren Wert als dem vorbestimmten Wert auf einen größeren Wert als den vorbestimmten Wert ansteigt.

11. Stromkreis nach Anspruch 10, umfassend eine Vielzahl von Stufen, die angeschlossen sind, um einen Zähler zu bilden, wobei jede Stufe einen der AMLs umfasst, der derart angeschlossen ist, dass der Zähler das Zählen nach einem Stromausfall wieder aufnimmt.

12. Stromkreis nach Anspruch 10, umfassend eine Vielzahl von Stufen, die angeschlossen sind, um ein eine Vielzahl von Bits speicherndes Schieberegister zu bilden, wobei jede Stufe einen der AMLs umfasst, der derart angeschlossen ist, dass das Schieberegister die Vielzahl von Bits während eines Stromausfalls bewahrt.

13. Verfahren zum Betreiben eines Stromkreises, der ausgeschaltet wurde, wobei der Stromkreis Folgendes umfasst: ein einen Stromkreiselementeingang und einen Stromkreiselementausgang umfassendes Stromkreiselement (91) und einen AML-Stromkreis, der Folgendes umfasst: einen transparenten Latch, umfassend einen Latch (93) und einen mit einem Eingang des Latch (93) verbundenen Eingangsschalter (95), und einen transparenten autonomen ferroelektrischen Memory-Latch (transparenten AML), umfassend einen autonomen ferroelektrischen Memory-Latch (AML) (92) und einen mit einem Eingang des AML (92) verbundenen Eingangsschalter (94), wobei der transparente Latch und der transparente AML in Reihe geschaltet sind, wobei der Stromkreiselementeingang mit dem Ausgang des transparenten Latch verbunden ist und der Stromkreiselementausgang mit dem Eingangsschalter (94) des transparenten AML verbunden ist, wobei der AML (92) einen autonomen Speicherstromkreis (20) und eine Rückkopplungsschleife umfasst, wobei der autonome Speicherstromkreis Folgendes umfasst: einen ferroelektrischen Kondensator (21), einen leitfähigen Verbraucher (22) und einen Schalter (23) mit einem strombetätigten Steuereingang (25), der einen Ausgangsknoten mit einer ersten Stromschiene verbindet, wobei der leitfähige Verbrauchter eine zweite Stromschiene mit dem Ausgangsknoten (26) verbindet, wobei der ferroelektrische Kondensator zwischen dem Schaltersteuereingang und dem Ausgangsknoten angeschlossen ist, wobei die Rückkopplungsschleife Folgendes umfasst: einen an die erste Stromschiene gekoppelten ersten Stromkontakt, einen an die zweite Stromschiene gekoppelten zweiten Stromkontakt, einen an den Ausgangsknoten (26) gekoppelten Rückkopplungssteuereingangsknoten und einen an den strombetätigten Steuereingang (25) gekoppelten Rückkkopplungsausgangsknoten, wobei der AML-Eingang an den strombetätigten Steuereingang (25) gekoppelt ist, der AML-Ausgang direkt an den Ausgangsknoten (26) gekoppelt ist, der erste AML-Stromkontakt direkt an die erste Stromschiene gekoppelt ist und der zweite AML-Stromkontakt direkt an die zweite Stromschiene gekoppelt ist, wobei der AML-Stromkreis einen mit dem Stromkreiselementausgang verbundenen AML-Stromkreiseingang und einen mit dem Stromkreiselementeingang verbundenen AML-Stromkreisausgang umfasst; wobei das Verfahren Folgendes umfasst:
Trennen des AML-Stromkreiseingangs von dem Stromkreiselementausgang und Trennen des transparenten Latch von dem transparenten AML;
Einschalten des Stromkreises unter Beibehaltung der Trennung;
Verbinden des transparenten AML mit dem transparenten Latch für einen ersten Zeitraum durch Schließen des Eingangsschalters (95) des transparenten Latch, nachdem der transparente AML einen darin gespeicherten Wert abgerufen hat;
Abtrennen des transparenten AML von dem transparenten Latch durch Öffnen des Eingangsschalters (95) des transparenten Latch;
Verbinden des Stromkreiselementausgangs mit dem AML-Eingang durch Schließen des Eingangsschalters (94) des transparenten AML; und
Abtrennen des transparenten AML von dem Stromkreiselementausgang durch Öffnen des Eingangsschalters (95) des transparenten AML.

## Revendications

1. Circuit comprenant:
un verrou de mémoire ferroélectrique autonome (176', 54, 92) ayant un circuit mémoire autonome et une boucle de réaction, **caractérisé en ce que** le circuit mémoire autonome comprend un condensateur ferroélectrique (21), une charge conductrice (22) et un commutateur (23) ayant une entrée de commande (25) mise en oeuvre par une entrée qui raccorde un noeud de sortie à un premier rail d'alimentation, la charge conductrice servant à raccorder un deuxième rail d'alimentation au noeud de sortie (26), le condensateur ferroélectrique étant connecté entre l'entrée de commande de commutation et le noeud de sortie, l'AML en question comprenant une entrée AML, une sortie AML, un premier contact d'alimentation AML, un deuxième contact d'alimentation AML et un état AML **caractérisé en ce que** la boucle de réaction comprend un premier contact d'alimentation couplé au premier rail d'alimentation, un deuxième contact d'alimentation couplé au deuxième rail d'alimentation, un noeud d'entrée de la commande de réaction couplé au noeud de sortie (26) et un noeud de sortie de réaction couplé à l'entrée de commande (25) mise oeuvre par le courant, l'entrée AML est couplée à l'entrée de commande (25) mise oeuvre par le courant, la sortie AML est couplée directement au noeud de sortie (26), le premier contact d'alimentation AML est couplé directement au premier rail d'alimentation, et le deuxième contact d'alimentation AML est couplé directement au deuxième rail d'alimentation; **caractérisé en ce que**
un premier commutateur (178, 58, 95) en série avec soit cette entrée AML soit cette sortie de l'AML;
un deuxième commutateur (177, 57, 94) en série avec soit l'autre entrée AML soit la sortie de l'AML;
un verrou (179, 52, 93) en série avec soit cette entrée AML soit cette sortie AML, le verrou étant positionné de manière à ce qu'il n'existe pas de chemin direct entre la sortie AML et l'entrée AML, et
un contrôleur de commutation configuré de manière à ouvrir ces premier et deuxième commutateurs avant que l'énergie électrique soit supprimée des contacts d'alimentation des premier et deuxième commutateurs d'alimentation AML.

2. Circuit selon la revendication 1, comprenant par ailleurs un élément de circuit configuré de manière à exécuter une opération sur la sorte AML ou fournir l'entrée AML.

3. Circuit selon la revendication 1, **caractérisé en ce que** le contrôleur de commutation est configuré de manière à empêcher la fermeture du premier commutateur et du deuxième commutateur en même temps.

4. Circuit selon la revendication 1, **caractérisé en ce que** soit le premier commutateur soit le deuxième commutateur font partie du verrou.

5. Circuit selon la revendication 1, **caractérisé en ce que** le circuit comprend un élément de circuit configuré de manière à effectuer une opération sur la sortie AML afin de produire un élément de circuit dont la sortie est accouplée à l'entrée AML par le verrou.

6. Circuit selon la revendication 5, **caractérisé en ce que** le verrou est situé entre la sortie AML et une entrée de l'élément de circuit, ou bien qui est situé entre une sortie de cet élément de circuit et la sortie AML.

7. Circuit selon la revendication 1, **caractérisé en ce que** les premier et deuxième commutateurs sont ouverts lorsqu'il n'y a pas d'alimentation énergie électrique prévue entre les premiers et deuxièmes contacts d'alimentation AML, et **caractérisé en ce que** le contrôleur de commutation est configuré de manière à fermer les premier et deuxième commutateurs dans un ordre prédéterminé après que l'énergie électrique a été fournie entre les premier et deuxième contacts d'alimentation AML.

8. Circuit selon la revendication 7, **caractérisé en ce que** le contrôleur de commutation est configuré de manière à retarder la fermeture soit du premier soit du deuxième commutateur pendant une certaine période après la fermeture du premier ou du deuxième commutateur, cette période étant suffisante pour permettre au circuit en question d'atteindre un état prédéterminé avant de fermer l'autre premier ou deuxième commutateur.

9. Circuit selon la revendication 1, comportant par ailleurs
un élément d'alimentation électrique et de stockage de l'énergie, l'alimentation électrique étant configurée de manière à alimenter les premier et deuxième contacts d'alimentation pendant une période suffisante pour que le contrôleur de commutation puisse ouvrir le premier et le deuxième commutateurs;
un moniteur d'alimentation électrique, ce moniteur étant configuré de manière à détecter une interruption de l'alimentation électrique et de mettre en oeuvre le contrôleur de commutation qui va commander les premier et deuxième commutateurs à la suite de cette interruption.

10. Circuit selon la revendication 1, comportant par ailleurs
une pluralité de ces AML intégrés dans des circuits logiques,
une première et une deuxième bornes d'alimentation, le circuit en question étant configuré de manière à être alimenté par un potentiel appliqué entre les premières et deuxièmes bornes d'alimentation; et
un circuit moniteur de l'énergie électrique, ce circuit moniteur de l'énergie électrique étant configuré de manière à surveiller le potentiel entre les première et deuxième bornes d'alimentation, ce circuit moniteur de l'énergie électrique étant configuré de manière à déconnecter les AML des éléments de circuit auxquels ils sont connectés lorsque le potentiel en question est inférieur à une valeur prédéterminée, et reconnecter les AML à ces éléments de circuit en une séquence prédéterminée de manière à ce que ce circuit reprenne son fonctionnement dans un état qui existait avant que le potentiel ne baisse à une valeur inférieure à cette valeur prédéterminée où le potentiel augmente à partir de cette valeur prédéterminée pour atteindre une valeur supérieure à cette valeur prédéterminée

11. Circuit selon la revendication 10 comprenant une pluralité d'étages connectés pour former un compteur, chaque étage comportant l'un de ces AML connecté de sorte que le compteur en question recommence à compter après une interruption de l'énergie électrique.

12. Circuit selon la revendication10 comprenant une pluralité d'étages connectés de manière à former un registre à décalage rangeant en mémoire une pluralité de bits, chaque étage comportant l'un de ces AML connecté de sorte que le registre à décalage retient la pluralité de bits en cas d'interruption de l'énergie électrique.

13. Procédé d'utilisation d'un circuit dont l'alimentation a été coupée, ce circuit comprenant un élément de circuit (91) une entrée d'élément de circuit et une sortie d'élément de circuit ainsi qu'un circuit AML comprenant un verrou transparent qui comporte un verrou (93) et un commutateur d'entrée (95) raccordé à l'une des entrées du verrou (93), ainsi qu'un verrou de mémoire ferroélectrique autonome et transparent, un AML transparent comportant un verrou de mémoire ferroélectrique autonome AML (92) et un commutateur d'entrée (94) connecté à une entrée de cet AML (92), ce verrou transparent et cet AML transparent étant connectés en série, l'entrée de cet élément de circuit étant connectée à la sortie du verrou transparent, et la sortie de l'élément de circuit étant connectée au commutateur d'entrée (94) de l'AML transparent, cet AML (92) comprenant un circuit mémoire autonome (20) et une boucle de réaction, **caractérisé en ce que** le circuit mémoire autonome comprend un condensateur ferroélectrique (21), une charge conductrice (22) et un commutateur (23) dont l'entrée mise en oeuvre par le courant (25) raccorde un noeud de sortie à un premier rail d'alimentation, la charge conductrice
raccordant un deuxième rail d'alimentation au noeud de sortie (26), le condensateur ferroélectrique étant connecté entre l'entrée de commande du commutateur et le noeud de sortie, la boucle de réaction qui comprenant : un premier contact d'alimentation couplé au premier rail d'alimentation, un deuxième contact d'alimentation couplé au deuxième rail d'alimentation, un noeud d'entrée du contrôle de réaction couplé au noeud de sortie (26) et un noeud de sortie de réaction couplé à l'entrée mise en oeuvre par le courant (25), l'entrée AML étant couplée avec l'entrée mise en oeuvre par le courant (25), la sortie AML étant couplée directement au noeud de sortie (26), le premier contact d'alimentation AML étant couplé directement au premier rail d'alimentation, et le deuxième contact d'alimentation AML étant couplé directement au deuxième rail d'alimentation, le circuit AML ayant une entrée de circuit AML connectée à la sortie de cet élément de circuit et une sortie de circuit AML étant connectée à cet élément de circuit, le procédé consistant:
à isoler l'entrée de ce circuit AML de la sortie de cet élément de circuit et d'isoler ce verrou transparent de l'AML transparent;
à mettre sous tension ce circuit, tout en maintenant l'isolement;
à connecter le AML transparent au verrou transparent pendant une première période en fermant le commutateur d'entrée (95) du verrou transparent après que le AML transparent ait rappelé une valeur qui y est rangée:
à déconnecter le AML transparent du verrou transparent en ouvrant le commutateur d'entrée (95) de ce verrou transparent;
à connecter la sortie de cet élément de circuit à l'entrée de l'AML en fermant le commutateur d'entrée (94) de cet AML transparent, et
à déconnecter cet AML transparent de la sortie de l'élément de circuit en ouvrant le commutateur d'entrée (95) de cet AML transparent.
